# EUROPEAN PATENT APPLICATION

(11) **EP 4 293 721 A1**
(43) Date of publication of application: **20.12.2023**
(21) Application number: 22179216.1
(22) Date of filing: 15.06.2022
(51) Int. Cl.: H01L 27/11, H01L 27/02, H01L 29/775, H01L 23/528

(54) **BIT CELL FOR SRAM**

(71) Applicant: Imec VZW, 3001 Leuven (BE); Katholieke Universiteit Leuven KU Leuven Research & Development, 3000 Leuven (BE)
(72) Inventor: LIU, Hsiao-Hsuan, 3001 Leuven (BE); SALAHUDDIN, Shairfe Muhammad, 3000 Leuven (BE); CHAN, Boon Teik, 3012 Wilsele (BE)
(74) Representative: AWA Sweden AB

(57) **Abstract**

A bit cell (10) for a Static Random-Access Memory, SRAM, is provided, comprising first and second sets of transistors. Each set comprises a pass-gate transistor (PG1, PG2) and a stacked complementary transistor pair of an upper transistor (11, 21) and a lower transistor (12, 22). A source/drain terminal of a lower transistor of each set of transistors is connected to a respective first power supply (31) extending in a first power supply track arranged below the lower transistor, whereas a source/drain terminal of an upper transistor of each set of transistors is connected to a respective second power supply (32) extending in a second power supply track arranged above the upper transistor.

## Description

### Technical field

The present invention relates to a bit cell for a Static Random-Access Memory (SRAM), as well as a method for forming such a bit cell.

### Background

In the strive to provide even more area-efficient circuit designs, vertically stacked semiconductor devices are being developed. One example is the so-called complementary field-effect transistor (FET) design in which two horizontal channel transistors are stacked above each other, such that the horizontal channel of a first one of the transistors is arranged above the horizontal channel of the other one of the transistors.

The development of vertically stacked designs has however led to challenges in forming electrical interconnection structures for interconnecting devices and structures as different vertical levels. The interconnection structures may include horizontal conductive paths or lines on different interconnections levels and vias extending vertically between the levels.

While continuing advances in miniaturisation of transistors would seem to allow ever smaller cell designs and thus denser circuits, the development of transistors of decreasing dimensions may by itself not be enough to enable area efficient circuitry. Indeed, also the interconnection structures providing signals and power to the transistors need consideration.

### Summary

An objective of the present invention is to provide a bit cell for an SRAM enabling an area efficient circuit design. Further and alternative objectives may be understood from the following.

According to a first aspect, a bit cell for an SRAM is provided, the bit cell comprising:
first and second sets of transistors arranged on a substrate, each set comprising a pass-gate transistor and a stacked complementary transistor pair of an upper transistor and a lower transistor;
wherein each transistor of the first set comprises a semiconductor channel extending between respective source and drain regions along a horizontal first channel track, and each transistor of the second set comprises a semiconductor channel extending between respective source and drain regions along a horizontal second channel track;
wherein the semiconductor channels of the lower transistors are arranged at a first level above the substrate and the semiconductor channels of the upper transistors are arranged at a second level, above the first level;
wherein the semiconductor channels of the pass-gate transistors are arranged at the first level or the second level;
wherein a source/drain terminal of the lower transistor of each set of transistors is connected to a respective first power supply extending in a first power supply track arranged below the lower transistor; and
wherein a source/drain terminal of the upper transistor of each set of transistors is connected to a respective second power supply extending in a second power supply track arranged above the upper transistor.

According to a second aspect, a method for forming a bit cell for an SRAM is provided, comprising forming, on a semiconductor substrate:
a first and a second set of transistors, each set including pass-gate transistor and a stacked, complementary transistor pair of an upper transistor and a lower transistor;
wherein each transistor of the first set comprises a semiconductor channel extending between respective source and drain regions along a horizontal first channel track, and each transistor of the second set comprises a semiconductor channel extending between respective source and drain regions along a horizontal second channel track;
wherein forming the first and second set of transistor comprises arranging the semiconductor channels of the lower transistors at a first level above the substrate, the semiconductor channels of the upper transistors at a second level, above the first level, and the semiconductor channel of the pass-gate transistors at the first level or the second level;
connecting source/drain terminal of the lower transistor of each set of transistors to a respective first power supply extending in a first power supply track arranged below the lower transistor;
connecting a source/drain terminal of the upper transistor of each set of transistors to a respective second power supply extending in a second power supply track arranged above the upper transistor.

The inventive concept is based on the insight that it may be challenging to form interconnecting structures, such as vertical interconnects for power supply, for bit cell designs having a reduced cell area. As the bit cell is scaled, the available space for the interconnecting structures are reduced accordingly. The inventors have realised that by arranging a first one of the power supplies above the bit cell and the other one below the bit cell, the bit cell can be efficiently powered also when the bit cell area has been reduced. This is particularly beneficial compared to prior art designs wherein both power supplies, i.e., both VDD and VSS, are arranged either below or on top of the bit cell. In case of nonplanar bit cell designs, the upper transistors would need to be connected to the power supply by means of vertical interconnect structures extending all the way up to the upper transistor level. Correspondingly, in case the power supplies are arranged on top of the bit cell, the lower transistors would need to be connected to the power supply by means of vertical interconnect structures extending all the way down to the lower transistor level. Such vertical interconnect structures may be challenging or even impossible to accommodate between adjacent semiconductor channel tracks when the cell is scaled to even smaller dimensions. When the cell height, or horizontal spacing between adjacent semiconductor channels, is reduced the available space for forming the vertical interconnects is reduced accordingly, eventually risking shortcuts and difficulties to balance the electrical resistance between different vertical level of the bit cell. By instead arranging one of the power supplies above the bit cell such that the upper transistor can be connected from above and the lower transistor from below, the number of vertical interconnect structures extending past one transistor level to reach another transistor level of the stack (for instance connecting an upper transistor to a power rail arranged below the bit cell) may be reduced, saving space for other vertical interconnects and a reduced channel track pitch.

When reducing the spacing between the channel tracks, the precision with which the vertical interconnects can be formed risks to be the limiting factor determining the minimum possible spacing between the channel tracks. The precision of the forming of the vertical interconnects relies, among other factors, on the precision of the available patterning techniques and the selectivity of the etch process used for defining the trench in which the interconnect is to be formed. Overlay and alignment errors in the lithographic patterning process require dimensional margins that risk hindering the spacing between the channel tracks to be reduced to even smaller dimensions. Further, by connecting the upper transistor from above, the length of the vertical interconnect used for connecting the transistor may be reduced, thereby facilitating the processing of said interconnect.

A complementary pair of transistors may comprise a pair of transistors having opposite channel types, i.e., an n-type transistor and a p-type transistor. The first and second complementary transistor pairs may be configured as a respective inverter pair. The two inverter pairs together form a pair of cross-coupled inverter by means of cross-couple contacts.

One of the transistors of each complementary transistor pair may be configured as a pull-up transistor and the other transistor of the pair may be configured as a pull-down transistor. The designation "pull-up", "pull-down" or "pass" for a transistor should herein be construed as said transistor being adapted to function or operate as a pull-up, pull-down or pass transistor in the context of the conventional understanding of (CMOS) inverters or SRAM bit cells.

The transistors may be field-effect transistors (FETs). The first complementary transistor pair may accordingly comprise a first CMOS pair, i.e., a first nFET (i.e., an n-type FET) and a first pFET (i.e., a p-type FET). Correspondingly, the second complementary transistor pair may comprise a second CMOS pair. The first and second pass transistors may each be an nFET or a pFET.

Each transistor comprises a semiconductor channel extending along a channel track, or fin track in case the transistor is a fin-based transistor such as a fin-FET. Two or more of the transistors may have channels extending along the same track, depending on the particular layout of the bit cell. A track, or channel track, may thus be defined as the horizontal geometrical line which the channel of a transistor is formed along and parallel to.

Further, it will be appreciated that the present inventive concept may be applied to nonplanar, or stacked, bit cell designs as well as planar bit cell designs.

Relative spatial terms such as "vertical", "upper", "lower" "stacked on top of" are herein to be understood as denoting locations or direction in relation to a normal direction to the substrate, or equivalently in relation to a bottom-up direction of the device layer stack. Correspondingly, terms such as "lateral" and "horizontal" are to be understood as location or directions parallel to the substrate, i.e., parallel to an upper surface or the main plane of extension of the substrate.

The second power supply track may be arranged at the same vertical level as a word line, which together with bit lines can be used to read and write information from or to the cell. Preferably, the word line and the second power supply may be arranged in a metal layer (M1) arranged above a local interconnect layer (MINT), accommodating the bit lines. In different words, the word line and power supply may be vertically separated from the bit lines to save space in the horizontal direction and allow for a more compact cell design with reduced circuit area.

In some embodiments, a word line may be connected to a respective gate of each of the pass-gate transistors by means of a local interconnect, such as a via connection. Further, a source/drain terminal of the pass-gate transistor of the first set of transistors may be connected to a first bit line (BL) and a source/drain terminal of the pass-gate transistor of the second set of transistors to a second bit line (BLB).

In some embodiments, the first power supply is formed as a buried power rail. The buried power rail may be formed by etching a recess or trench into the substrate, at a position below the lower transistor, and filling the recess or trench with an electrically conducting material. A via connection, such as a through-silicon via (TSV) may be provided to connect the power supply to the lower transistor.

In some embodiments, the bit cell further comprises a first inverter gate electrode forming a common gate electrode for the semiconductor channels of the complementary transistor pair of the first set of transistors, as well as a second inverter gate electrode forming a common gate electrode for the semiconductor channels of the complementary transistor pair of the second set of transistors. The first and second inverter gate electrodes extend in a respective horizontal gate track transverse to the channel tracks. Further, the bit cell comprises a first pass gate electrode forming a gate of the first pass-gate transistor and being aligned with the first inverter gate electrode, and a second pass gate electrode forming a gate of the second pass-gate transistor and being aligned with the second inverter gate electrode. To allow a further reduction of the spacing between adjacent channel tracks and thus a reduced cell height, dielectric walls may be provided to separate gate structures from each other. The use of dielectric walls is particularly beneficial compared to conventional technology in which the gate electrodes are formed by a gate cut, in which a continuous gate electrode is etched and split into two separate electrodes that are separated from each other. When reducing the spacing between the channel tracks, the precision with which the gate cut can be performed risks to be the limiting factor determining the minimum possible spacing between the channel tracks. The precision of the gate cut relies, among other factors, on the precision of the available patterning techniques and the selectivity of the etch process used. Overlay and alignment errors in the lithographic patterning process require dimensional margins that risk hindering the spacing between the channel tracks to be reduced to even smaller dimensions. The inventors have realised that by replacing the gate cut with a dielectric wall, which may be formed prior to the gate electrodes, the end portions of two aligned gate electrodes can be separated at a tighter pitch that otherwise would have been possible. As the thickness of the separating wall may be more easily and precisely controlled than the lithographic patterning and etching involved in the gate cutting process, the space and margins required for providing the gate electrode separation may be reduced.

It will be appreciated that two or more of the gate electrodes (e.g., inverter gate electrodes and the pass gate electrodes) may extend along the same gate tracks. A gate track may thus be defined as the horizontal geometrical line which gate electrodes are formed along and parallel to. Preferably, the gate tracks are orthogonal to the channel tracks.

As the first inverter gate electrode forms a common gate electrode for the semiconductor channels of the first pair of complementary transistors, the first inverter gate electrode may be configured to control the conductivity of both semiconductor channels of the first pair of complementary transistors. The first inverter gate electrode may enclose the semiconductor channels of the first pair of complementary transistors partially or completely.

As the second inverter gate electrode forms a common gate electrode for the semiconductor channels of the second pair of complementary transistors, the second inverter gate electrode may be configured to control the conductivity of both semiconductor channels of the second pair of complementary transistors. The second inverter gate electrode may enclose the semiconductor channels of the second pair of complementary transistors partially or completely.

As the first pass gate electrode forms a gate for the semiconductor channel of the first pass-gate transistor, the first pass gate electrode may be configured to control the conductivity of the semiconductor channel of first pass-gate transistor. The first pass gate electrode may enclose the first pass-gate transistor channel partially or completely.

As the second pass gate electrode forms a gate for the semiconductor channel of the second pass-gate transistor, the second pass gate electrode may be configured to control the conductivity of the semiconductor channel of second pass-gate transistor. The second pass gate electrode may enclose the second pass-gate transistor channel partially or completely.

In some embodiments, the first and second dielectric wall may extend vertically between the first and second level and horizontally between the vertical stacks of complementary transistors. The presence of the insulating wall provides electrical separation between the pass-gate electrodes and the inverter gate electrodes also in vertical layouts, thereby allowing the spacing between neighbouring channel tracks to be even further reduced. Due to the vertical layout of the bit cell the first and second dielectric wall may form a common wall, i.e., form part of the same wall structure.

The inventive configuration of the bit cell allows for dielectric walls having a thickness of 10 nanometres (nm) or less, such as 8 nm or less.

The semiconductor channel of each transistor may in some examples be formed of a respective fin portion. Such a structure may also be referred to as an elongated layer stack with a longitudinal dimension oriented along the substrate, in a channel track, and protruding vertically therefrom. Further, the semiconductor channel of one or more transistor may advantageously be formed in one or more horizontal semiconductor nanowires. The gate electrodes may accordingly be configured as gate all around electrodes completely enclosing/wrapping around the channel region of the respective one or more nanowires. A horizontal semiconductor nanowire may here refer to a semiconductor structure extending horizontally along the substrate and being suspended above the substrate. The nanowire may form a semiconductor body having a closed circumferentially extending bounding surface. Various later aspect ratios are possible, such as a width to height ratio close to unity, or a width to height ratio greater than one (such as a horizontally oriented nano-sheet semiconductor structure) or smaller than one (such as a vertically oriented nano-sheet). The source and drain regions of the transistor may also be formed in opposite ends of the nanowire. Source and drain contacts of the transistor may completely enclose/wrap around the source and drain regions of the respective one or more nanowires.

The dielectric wall may be formed by depositing a dielectric material in a gap defined by sidewall spacers arranged on neighbouring fin portions, or elongated layer stacks, as will be discussed in further detail with reference to the drawings. This allows for the thickness of the dielectric wall to be defined by the thickness of the sidewall spacers, and the sidewall to be self-aligned between the fins.

### Brief description of drawings

The above, as well as additional object, features and advantages, may be better understood through the following illustrative and non-limiting detailed description, with reference to the appended drawings. In the drawings like reference numerals will be used for like elements unless stated otherwise.
Figures 1a and b show horizontal cross sections of a bit cell, taken at two different vertical levels.
Figures 2a-c show vertical cross sections through the bit cell in figures 1a and b.
Figures 3a-e are perspective views illustrating various steps during the formation of the dielectric wall.

### Detailed description

A bit cell for an SRAM arranged on a semiconductor substrate, as well as methods for forming such a bit cell, will in the following be described with reference to the figures.

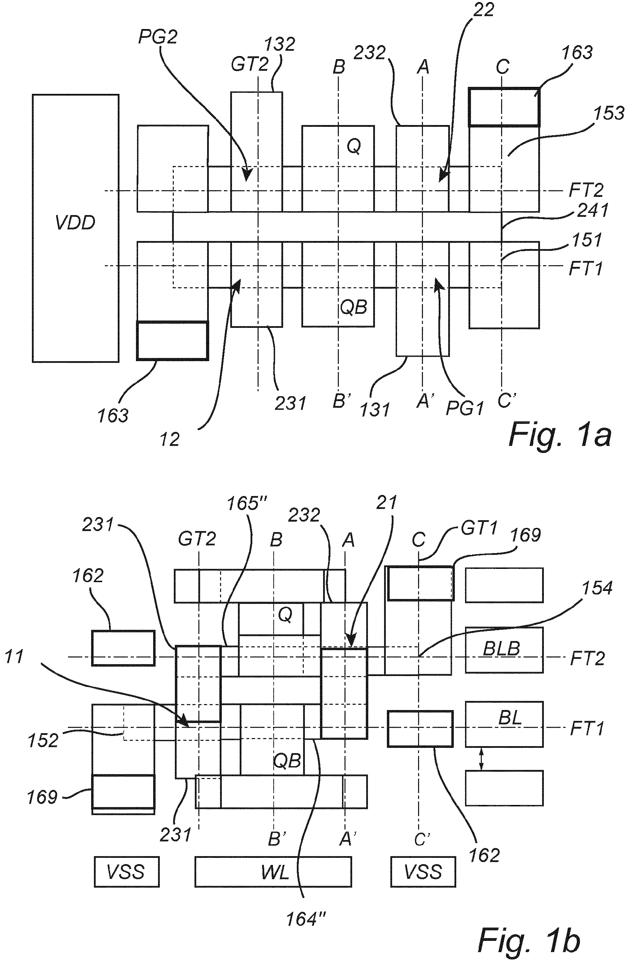

In figures 1a and b there is shown schematic cross sections of a bit cell 10, taken at different vertical levels. Figure 1a shows a cross section at a first, lower level (i.e., closer to the substrate) and figures 1b show a cross section at second, upper level (i.e., above the first level). The bit cell 10 comprises a first lower transistor 12 and a second lower transistor 22 arranged at the first level shown in figure 1a, as well as a first upper transistor 11 and a second upper transistor 21 arranged at the second level shown in figure 1b. The first lower transistor 12 and the first upper transistor 11 form a complementary transistor pair stacked on top of each other and are thus aligned in the vertical direction such that their respective horizontal channel portions extend along the same channel track FT1. The same applies to the second lower transistor 22 and the second upper transistor 21, which also form a complementary transistor pair stacked on top of each other and having horizontal channel portions aligned along a common channel track FT2. The bit cell 10 further comprises pass-gate transistors PG1, PG2, which may be arranged at the first or second level. In the present example, they are arranged at the lower level shown in figure 1a. Each of the pass-gate transistors PG1, PG2 may have a channel portion extending along the same track as the channel portion of one of the complementary transistors, such as the first lower transistor 12 (for the second pass-gate transistor PG2) and the second lower transistor 22 (for the first pass-gate transistor PG1) in figure 1a. The tracks, or channel tracks FT1, FT2 represent different parallel geometrical tracks or geometrical planes which the semiconductor channels of the transistors are formed along and parallel to. As will be described below, the semiconductor channels of the transistors may be formed of a respective fin structure and the channel tracks FT1, FT2 may therefore also be referred to as fin tracks. Accordingly, the channel tracks FT1, FT2 correspond to the longitudinal direction of the fin structures from which the semiconductor channels may be formed.

The complementary transistor pairs may be implemented in an SRAM cell, in which the first upper transistor 11 is operated as a first pull-down transistor PD1, the second upper transistor 21 as a second pull-down transistor PD2, the first lower transistor 12 as a first pull-up transistor PU1, and the second lower transistor 22 as a second pull-up transistor PU2. It should however be noted that this is an example illustrating an embodiment of the concept disclosed herein, and that other configurations are conceivable as well. As already mentioned, the pass-gate transistors PG1, PG2 may in alternative layouts be arranged at the upper level instead. Further, the bit cell may comprise pull-down transistors PD1, PD2 arranged at the lower level instead, whereas the pull-up transistors PU1, PU2 may be arranged at the upper level.

Further indicated in figures 1a and b are first and second gate tracks GT1, GT2. The gate tracks GT1, GT2 extend transverse to and across the channel tracks FT1, FT2. Similar to the channel tracks FT1, FT2 the gate tracks GT1, GT2 represent different parallel geometrical tracks or geometrical lines along which the gate electrodes of the bit cell 10 are distributed. The gate electrode may be formed in respective gate tranches in one or more dielectric layer embedding the bit cell 10. Accordingly, GT1 and GT2 may be understood as representing the longitudinal directions of the gate trenches in which the gate electrodes as formed. Using what may be referred to as a "sequential" process, a bit cell 10 comprising bottom and top transistors may be formed by processing the bottom device first. Thereafter, the channel region of the upper transistor may be provided with a gate stack which is electrically connected to the gate stack of the bottom device. Hence, in the sequential process the gate electrodes of the lower device and the upper device may be formed as separate electrodes which are interconnected vertically to form the inverter gate electrodes as discussed above.

The sequential process differs from the so-called "monolithic" process, in which the bottom and top devices may be provided with a "monolithic" gate stack defining a gate electrode which is physically and electrically common to the top and bottom device. While both the sequential processing and the monolithic processing are possible within the scope of the present disclosure, a monolithic process for forming the inverter gate electrodes will be discussed in the following illustrating example.

In figures 1a and b a first inverter gate electrode 231 forms a common gate electrode for the semiconductor channel of the first pull-down transistor 11 and the first pull-up transistor 12, whereas a second inverter gate electrode 232 forms a common gate electrode for the semiconductor channels of the second pull-down transistor 21 and the second pull-up transistor 22. With this arrangement, the first inverter gate electrode 231 is allowed to control the conductivity of both semiconductor channels of the first pair of complementary transistors and the second inverter gate electrode 232 is allowed to control the conductivity of both semiconductor channels of the second pair of complementary transistors. Further, a first pass gate electrode 131 is arranged to form a gate of the first pass-gate transistor PG1 and a second pass gate electrode 132 is arranged to form a gate of the second pass-gate transistor PG2. The first pass gate electrode 131 and the second inverter gate electrode 232 are distributed along the first gate track GT1, such that they are aligned with each other. Similarly, the second pass gate electrode 132 and the first inverter gate electrode 231 are distributed along the second gate track GT2 and aligned with each other. Further, two cross-coupling structures 164", 165" are arranged to connect the inverter gate electrodes 231, 232 to the first and second node Q, QB, respectively. This may also be referred to as a "spacer merge", forming the cross-couple feedback.

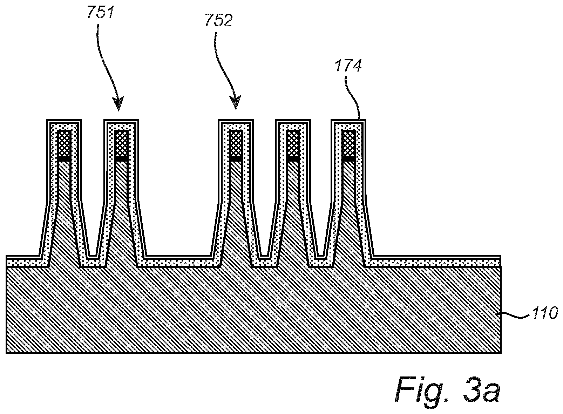

Figure 1a also shows a dielectric wall 241, which according to some configurations may be formed in a trench separating the first inverter gate electrode 231 and the second pass gate electrode 132 as well as the second inverter gate electrode 232 from the first pass gate electrode 131. The illustrated wall is an example of how to separate different gate electrodes, sharing a common gate track, from each other. The dielectric wall 241 may hence be understood as a body extending between an end portion of an inverter gate electrode 231, 232 and an end portion of a pass gate electrode 131, 132 extending along a common gate track GT1, GT2 and arranged in mutual abutment with the body. The presence of the dielectric wall 241 allows for the electrodes in the respective gate tracks GT1, GT2 to be electrically separated from each other to ensure proper operation of the bit cell 10. It will be appreciated that further dielectric walls (not shown) may be provided to separate the inverter gate electrodes from neighbouring devices, such as adjacent bit cells of an array of bit cells. The dielectric walls may be formed in a method outlined below in connection with figures 3a-e. Other processes for forming such dielectric wall(s) are however possible.

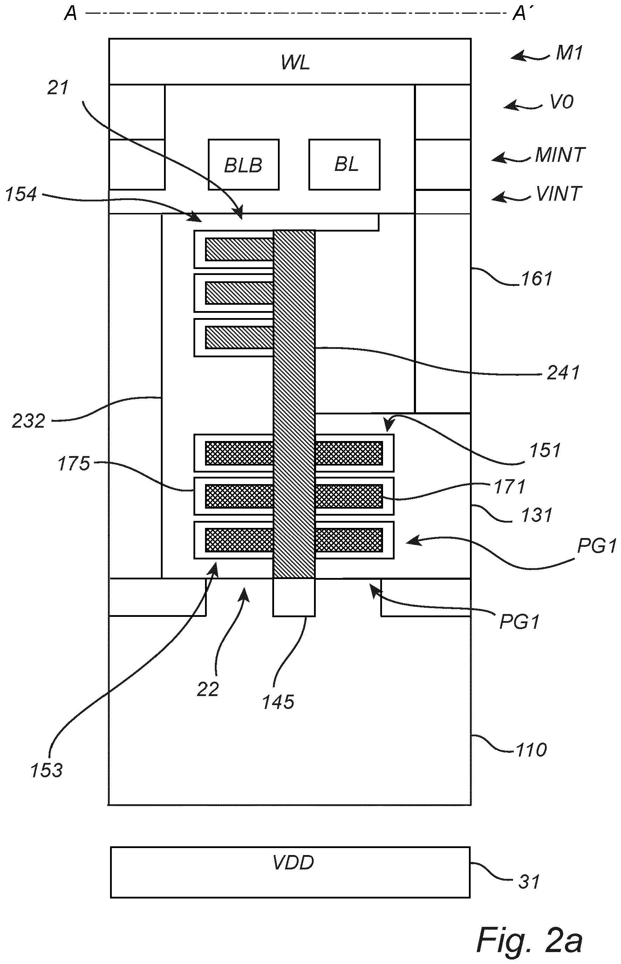

Various configurations of the active regions of the fin structures 151-154 are possible. Each fin structure 151-154 may, for instance, comprise a stack of channel nanosheets (as illustrated below in figures 2a-c). In other configurations the active region may comprise a single channel structure, such as a fin, nanowire or nanosheet. The gate structure may be a wrap-around gate structure, completely enclosing the channel structure, or of a so-called forksheet type in which the gate structure wraps around only a part of the channel structure. In the latter case, the dielectric wall 241 may form part of the forksheet wall separating the channel structures of the first pass-gate transistor PG1 and the second pull-up transistor 22, as well as the channel structures of the second pass-gate transistor PG2 and the first pull-up transistor 12. In the present figures, however, a monolithic nanosheet configuration is illustrated, rather than a forksheet or fin configuration.

The bit cell 10 illustrated in the cross sections in figures 1a and b may correspond to one functional cell in an array of a plurality of corresponding functional cells, for instance an array of identical bit cells or some other logic cell. Hence, the resulting circuit layout may comprise a plurality of regularly spaced and parallel channel tracks, a plurality of regularly spaced and parallel gate tracks, and a plurality of regularly spaced and parallel contact tracks. The tracks may together define a regular grid. The gate electrodes may be disposed at the intersections between the channel tracks and the gate tracks. The source/drain contacts may be disposed at the intersections between the channel tracks and the contact tracks. The semiconductor channels of the transistors may extend along the channel tracks, between source/drain contact pairs. A merit of using a dielectric wall for separating gate electrodes extending along the same gate tracks is that the spacing or pitch between the channel tracks may be further reduced.

The first and second pass-gate transistors PG1, PG2 may be n- or p-type FETs, such as an nMOSFET or pMOSFET. The first and second pull-up transistors 12, 22 may be p-type FETS, such as pMOSFETs, whereas the first and second pull-down transistors PD1, PD2 may be n-type FETs, such as nMOSFETs. Hence, the first and second complementary transistor pairs, also referred to as CFETs, may form a respective CMOS transistor pair.

Although the SRAM bit cell shown in figures 1a and b is a 6-transistor (6T) SRAM bit cell it should be noted that the design may also be used in other SRAM topologies as well, such as 4T to 10T bit cell designs.

In the above a bit cell 10 in accordance with the inventive concept has mainly been described with reference to a limited number of examples. However, as is readily appreciated by a person skilled in the art, other examples than the ones disclosed above are equally possible within the scope of the inventive concept, as defined by the appended claims.

The operation of the bit cell 10 is controlled by signal lines in the form of complementary bit lines BL, BLB and a word line WL, as well as power supply line VDD, VSS. The position of the signal lines BL, BLB and WL, the power supply lines VDD, VSS and interconnecting structures are indicated in figures 1a and b and which will now be discussed in further detail with reference to figures 2a-c.

Figure 2a is a vertical cross section along the line A-A' indicated in figures 1a and b, that is, orthogonally through the gate of the second pull-up transistor 22, the second pull-down transistor 21, and the first pass-gate transistor PG1. In the present example the transistor channels and source/drain regions of the transistors are formed in nanowire-shaped semiconductor structures 151, 153, 154 with a height to width ratio being less than one. However, other designs are also possible, such as nanosheets having a dimension greater than a thickness dimension, or a thickness dimension greater than a lateral dimension. Further, as mentioned above, the transistors PG1, 21, 22 may also be of a forksheet configuration, separated by the dielectric wall 241.

The insulating dielectric wall 241 extend in figure 2a vertically between the first pass-gate transistor PG1 and the second pull-up transistor 22, thereby providing electrical separation between the first pass gate electrode 131 and the second inverter gate electrode 232. The dielectric wall 241 extends from a shallow trench insulation (STI) 241' arranged at the top surface of the substrate 110 all the way up to the second pull-down transistor 21 arranged at the upper level shown in figure 1b.

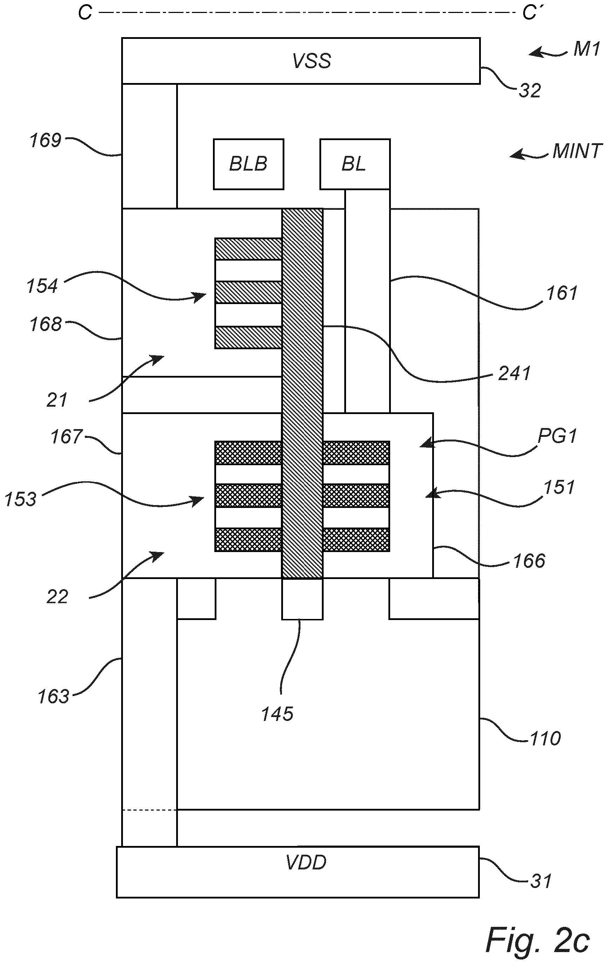

Figure 2a also indicates the tracks for the signal lines and the power supply lines discussed above. A first power supply (VDD in the present example) is arranged in a power rail 31 below the upper surface of the substrate 110 to connect a source/drain terminal of the second pull-down transistor 22 from below, as shown in figure 2c. The complementary bit lines BL, BLB are arranged in a local interconnect layer MINT above the transistor stack, whereas the word line WL is arranged in a metal layer M1 arranged above the MINT layer and connected to the first pass gate electrode PG1 by means of a vertical interconnect 161 extending from the M1 layer, through the V0, MINT and VINT layers and the upper transistor layer all the way down to the lower transistor layer in which the pass-gate transistor PG1 is arranged.

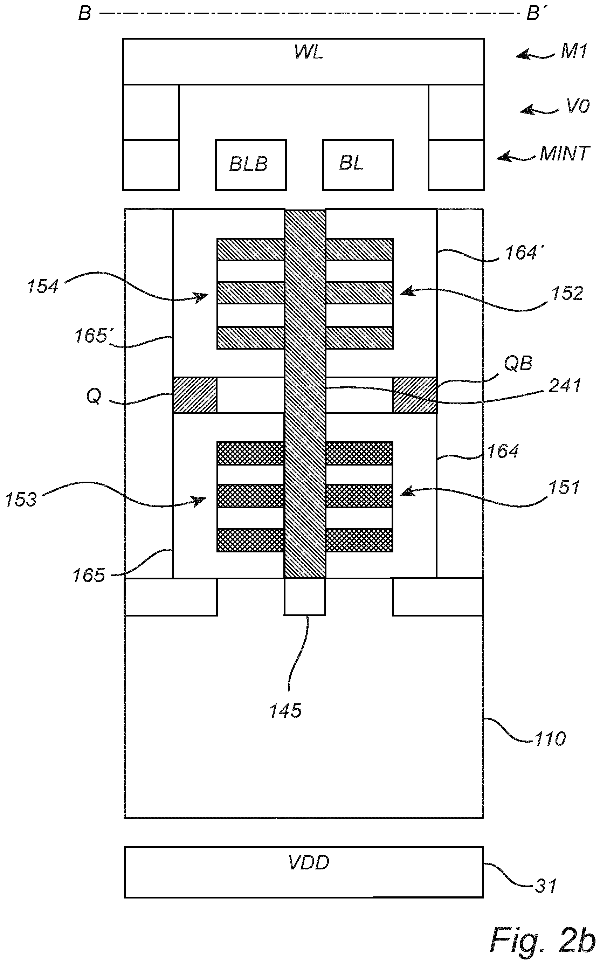

Figure 2b is a vertical cross section along the line B-B' indicated in figures 1a-b, that is, between the two pairs of complementary transistors and orthogonally through the fin structures 151-154 in which the transistors are formed. The cross section shows the interconnection structures 164, 164' interconnecting the source/drain terminals of the first pass-gate transistor PG1 and the first pull-up transistor 12 in the lower level with the source/drain terminal of the first pull-down transistor 11 in the upper level, as well as the interconnection structures 165, 165' interconnecting the source/drain terminals of the second pass-gate transistor PG2 and the second pull-up transistor 22 in the lower level with the source/drain terminal of the second pull-down transistor 21 in the upper level. Each of the top interconnection structures 164', 165' are connected to a bottom interconnection structure 164, 165 via a respective merging structure, also referred to as M0A merge, to form the internal nodes Q, QB of the bit cell.

Figure 2c is a similar cross section as the ones in figures 2a and b, taken across line C-C' in figures 1a and b. This cross section is hence taken through the source/drain region of the first pass-gate transistor PG1 formed in the first fin structure 151, through the source/drain region of the second pull-up transistor 22 formed in the third fin structure 153, and through the source/drain region of the second pull-down transistor 21 formed in the fourth fin structure 154. As indicated, a second power supply 32 (in this example VSS) is arranged in the metal layer M1 above the MINT layer and connected to the source/drain terminal of the second pull-down transistor 21 by means of a via structure 169. The second pull-down transistor 21 is thereby connected to the power supply line from above, in contrast to the second first pull-up transistor 22 which is connected to the power supply line 31 from by means of a vertical interconnect structure, such as a through-silicon via 163, extending vertically from the power rail up to the lower level in which the second pull-up transistor 22 is arranged

The bit line BL is here connected to the source/drain contact 166 of the first pass-gate transistor PG1 by means of a vertical interconnect 161 extending from the MINT layer down to the lower level in which the pass-gate transistor PG1 is arranged.

Although reference herein is made to "drain region"/"source region" and "drain contact"/"source contact" of a transistor it should be noted that the actual function of the region/contact may depend on the direction of the current flowing through the transistor. Hence, "drain" and "source" should be construed broadly as mere labels for the two different regions/contacts of a transistor. Reference to a "drain" region of a transistor may hence be interpreted as reference to a "first source/drain" region of the transistor and reference to a "source" region of the transistor as a reference to a "second source/drain" region of the transistor, and correspondingly for "source" contact and "drain" contact.

A method for forming a dielectric wall in a bit cell similar to the ones disclosed above in connection with figures 1 and 2 will now be discussed with reference to the perspective views in figures 3a-e. It should be noted that the proposed method is an illustrating example and that other methods are possible as well, depending on the particular performance requirements and the layout of the bit cell 10. The dielectric wall 241 may be employed in some embodiments of the present invention concept to facilitate electrical separation between different gate electrodes. Further, it will be appreciated that several different processes may be used for forming structures separating the gate electrodes. The following process merely to be seen as an illustrating example, and not necessarily limiting the scope of the embodiments defined in the appended claims.

In figure 3a, a plurality of elongated semiconductor structures 751, 752 has been formed on a substrate 110. The substrate 110 may be a conventional semiconductor substrate suitable for CMOS processing. The substrate 110 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate.

Each of the plurality of elongated semiconductor structures 751, 752 may be formed by an elongated fin-shaped layer stack with a longitudinal dimension oriented in a first horizontal direction along the substrate 110 and protruding in a vertical direction from the substrate 110. The elongated semiconductor structures 501-504 may hence be referred to as fin structures. A width dimension of the fin structure is oriented in a second horizontal direction transverse to the first horizontal direction.

Each fin structure 751, 752 may comprise, in a bottom-up direction, a lower device sub-stack, a middle insulating layer on the lower device sub-stack, and an upper device sub-stack on the middle insulating layer (not shown in figures 3a-e). The device sub-stacks may be considered to correspond to the fin structures 151-154 shown in figures 1 and 2. In the present figures, a capping layer 174 is arranged on the fin structures 751, 752.

Various configurations of the sub-stacks are possible. Each sub-stack may, for instance, comprises a number of channel nanosheets and a number of sacrificial nanosheets arranged alternatingly with the channel nanosheets, as seen along the vertical direction. In other configurations, a sub-stack may comprise a single channel structure, such as a fin, nanowire or nanosheet.

The sacrificial nanosheets may be formed of a semiconductor material ("sacrificial material") different from a semiconductor material of the channel nanosheets ("channel material") and selected to be removable selectively to the channel material. As used herein, the term "selective" in connection with removal of a material or feature (e.g., a layer or layer portion) means that the material of feature is removed/removable using an etching process etching the material/feature at a rate greater than another material/feature exposed to the etching process. The sacrificial material may be SiGeₓ and the channel material SiGe_{y}, wherein x, y ≥ 0 and y ≠ x. A difference in Ge-content of the sacrificial material and the channel material may facilitate a selective removal of the sacrificial material with respect to the channel material.

A channel material of Si in the lower sub-stacks and a channel material of SiGe in the upper sub-stacks allows for a CFET device comprising a lower FET of an n-type and an upper FET of a p-type to be formed. A SiGe upper channel material may enable forming of a strained upper channel layer, which may improve the performance of the channel for the upper FET. More generally, the Ge-content of the channel material of the lower and upper FET devices may be selected to optimize the channel properties for the devices.

The nanosheets and layers of the fin structures may each be epitaxial nanosheets and layers, e.g. formed of epitaxially grown or deposited semiconductor material. Epitaxial techniques, such as chemical vapour deposition (CVD) or physical vapour deposition (PVD) of Si and SiGe, allowing forming of high-quality material crystalline (e.g. single-crystalline) nanosheets or layers are per se known in the art.

The middle insulating layer may be formed of an insulating material, such as an oxide or a nitride. For example, the middle insulating layer may comprise or be formed of SiO₂, SiN, SiC, SiCN, SiOCN, SiOBCN or SiON. Although referred to and illustrated as a single layer, the middle insulting layer may also be formed as a composite layer structure comprising a stack of two or more different insulating layers.

The fin structures 751, 752 may be patterned by using a hard mask layer as an etch mask. Conventional patterning techniques may be used for patterning the hard mask layer, e.g., single patterning techniques such as lithography and etching ("litho-etch") or multiple-patterning techniques such as (litho-etch)x, self-aligned double or quadruple patterning (SADP or SAQP). The pattern defined by the hard mask may then be transferred into the layer stack by etching using the hard mask as an etch mask, resulting in the parallel fin-structures 751, 752extending along fin tracks FT1, FT2 as shown in e.g. figure 2a and b.

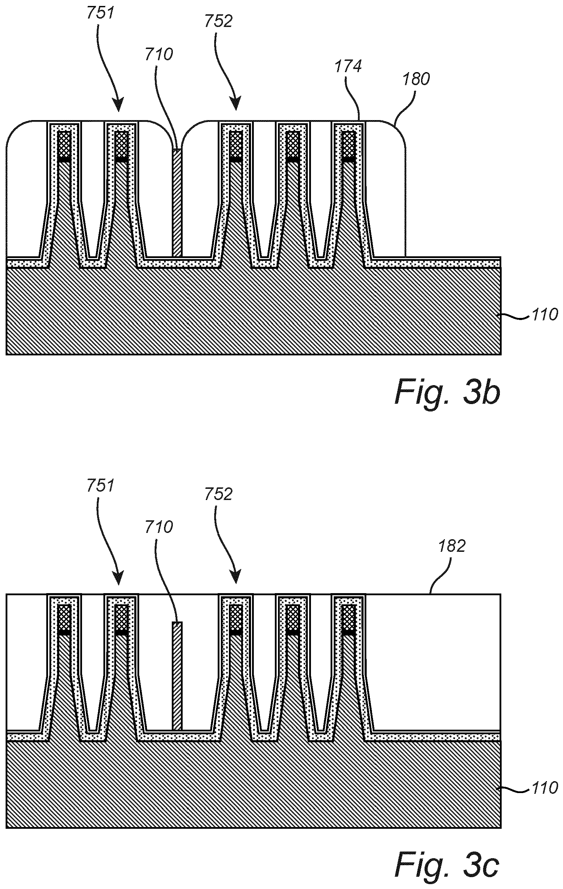

In figure 3b a spacer material layer 180 has been conformally deposited on the fin structures 751, 752 to form a reduced-width gap between the fin structures 751, 752. The gap is then filled with a dielectric material forming the dielectric isolating wall, which may be used for separating different gate tracks of the bit cell.. The spacer material layer may for example be an ALD-deposited nitride or carbide, such as SiN, SiCO, SiOCN, or SiC, or amorphous silicon (a-Si). The spacer material layer may be etched back (e.g., top-down, in the vertical direction towards the substrate) using an anisotropic etch process, such as reactive ion etching. It will be appreciated that the spacer layer 180 allows the width of the gap between neighbouring fin structures 751, 752 to be trimmed to define the thickness of the dielectric wall 710 formed therebetween. Beneficially, this process allows the dielectric wall 710 to be self-aligned between the channel tracks FT1-FT4. The dielectric wall 710 may be formed by conformal deposition of a dielectric material such as, for instance, SiCO or Al₂O₃, which may be added in single layer or a plurality of layer.

In figure 3c an isolating material 182, such as SiO₂, has been deposited conformally over the fin structures 751, 752, the spacer layer 180 and the dielectric wall 710. The isolating material 182 may be of the same type as the spacer layer 180, which hence may be considered to have been "topped up" in figure 7c. A CMP process has then been performed to remove excess material, landing on the capping layer 174.

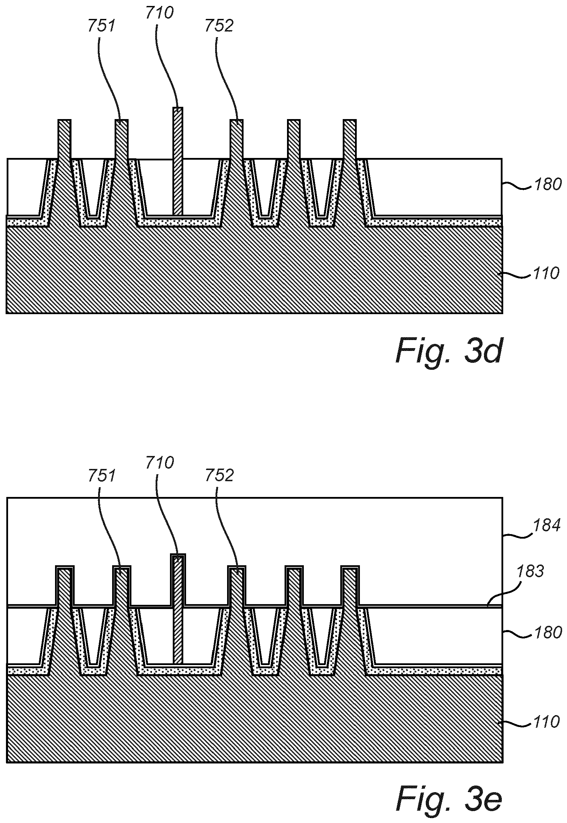

In figure 3d, a fin reveal process has been performed, in which the isolating material 182 has been etched back and the top portion of the fin structures 751, 752 as well as the top portion of the dielectric wall 710 have been revealed. Thereafter, an additional layer 183 of e.g. SiO₂ followed by a dummy gate layer 184 of e.g. a-Si has been formed, as shown in figure 3e. The dummy gate layer 184 may form part of a RMG process, resulting in the formation of a final gate stack replacing the dummy gate. The final gate stack may comprise a gate dielectric layer, one or more effective work function metal (WFM) layers and a gate fill metal. The gate dielectric layer may be formed of a conventional high-k dielectric, such as HfO₂, HfSiO, LaO, AIO or ZrO. The WFM layer may be formed of one or more effective WFMs (e.g. an n-type WFM such as TiAl or TiAIC and/or a p-type WFM such as TiN or TaN). The gate fill metal may be formed of conventional gate fill metals, such as W, Al, Co or Ru.

After the gate forming process, the method may proceed with forming source/drain contacts as well as interconnect structures, resulting in the structure shown in for example figures 1a-b and 2a-c.

In the above, the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A bit cell (10) for a Static Random-Access Memory, SRAM, the bit cell comprising:
first and second sets of transistors arranged on a substrate, each set comprising a pass-gate transistor (PG1, PG2) and a stacked complementary transistor pair of an upper transistor (11, 21) and a lower transistor (12, 22);
wherein each transistor of the first set comprises a semiconductor channel extending between respective source and drain regions along a horizontal first channel track (FT1), and each transistor of the second set comprises a semiconductor channel extending between respective source and drain regions along a horizontal second channel track (FT2);
wherein the semiconductor channels of the lower transistors are arranged at a first level above the substrate and the semiconductor channels of the upper transistors are arranged at a second level, above the first level;
wherein the semiconductor channels of the pass-gate transistors are arranged at the first level or the second level;
wherein a source/drain terminal of the lower transistor of each set of transistors is connected to a respective first power supply (31) extending in a first power supply track arranged below the lower transistor; and
wherein a source/drain terminal of the upper transistor of each set of transistors is connected to a respective second power supply (32) extending in a second power supply track arranged above the upper transistor.

2. The bit cell according to claim 1, wherein a gate of each of the pass-gate transistors is connected to a respective word line (WL) extending in a word line track arranged at the same vertical level as the second power supply track.

3. The bit cell according to claim 2, wherein:
a source/drain terminal of the pass-gate transistor of the first set of transistors is connected to a first bit line (BL);
a source/drain terminal of the pass gate transistor of the second set of transistors is connected to a second bit line (BLB); and
the first and second bit lines extend in a respective bit line track arranged at a level between the pass-gate transistors and the word line tracks.

4. The bit cell according to any of the preceding claims, wherein the first power supply is formed as a buried interconnect.

5. The bit cell according to any of the preceding claims, further comprising:
a first inverter gate electrode (231) forming a common gate electrode for the semiconductor channels of the complementary transistor pair of the first set of transistors and a second inverter gate electrode (232) forming a common gate electrode for the semiconductor channels of the complementary transistor pair of the second set of transistors, wherein the first and second inverter gate electrodes extend in a respective horizontal gate track transverse to the channel tracks:
a first pass gate electrode (131) forming a gate of the first pass-gate transistor and being aligned with the first inverter gate electrode;
a second pass gate electrode (132) forming a gate of the second pass-gate transistor and being aligned with the second inverter gate electrode;
a dielectric wall (241) formed in a trench separating the first pass gate electrode from the first inverter gate electrode and the second pass gate electrode from the second inverter gate electrode.

6. The bit cell according to claim 5, wherein the first and second dielectric wall extend vertically between the first and second level and horizontally between the stacks of complimentary transistor pairs.

7. The bit cell according to claim 5 or 6, wherein an average thickness of the first and second dielectric wall is 10 nm or less.

8. The bit cell according to any the preceding claims, wherein the semiconductor channel of each transistor is formed of a respective fin portion, nanosheet portion, or nanowire portion.

9. The bit cell according to any of the preceding claims, wherein the semiconductor channel of each transistor comprises a vertical stack of nanosheet portions or nanowire portions.

10. A method for forming a bit cell for a Static Random-Access Memory, SRAM, comprising forming, on a semiconductor substrate:
a first and a second set of transistors, each set including pass-gate transistor and a stacked, complementary transistor pair of an upper transistor and a lower transistor;
wherein each transistor of the first set comprises a semiconductor channel extending between respective source and drain regions along a horizontal first channel track, and each transistor of the second set comprises a semiconductor channel extending between respective source and drain regions along a horizontal second channel track;
wherein forming the first and second set of transistor comprises arranging the semiconductor channels of the lower transistors at a first level above the substrate, the semiconductor channels of the upper transistors at a second level, above the first level, and the semiconductor channel of the pass-gate transistors at the first level or the second level;
connecting source/drain terminal of the lower transistor of each set of transistors to a respective first power supply extending in a first power supply track arranged below the lower transistor;
connecting a source/drain terminal of the upper transistor of each set of transistors to a respective second power supply extending in a second power supply track arranged above the upper transistor.

11. The method according to claim 10, further comprising:
connecting a gate of each of the pass-gate transistors to a respective word line extending in a word line track arranged at the same vertical level as the second power supply tracks.

12. The method according to claim 11, further comprising:
connecting a source/drain terminal of the pass-gate transistor of the first set of transistors to a first bit line; and
connecting a source/drain terminal of the pass-gate transistor of the second set of transistors to a second bit line;
wherein the first and second bit lines extend in a respective bit line track arranged at a level between the pass-gate transistors and the word line tracks.
